# EUROPEAN PATENT APPLICATION

(11) **EP 1 498 941 A2**
(43) Date of publication of application: **19.01.2005**
(21) Application number: 04016213.3
(22) Date of filing: 09.07.2004
(51) Int. Cl.: H01L 21/311, C07C 17/00

(54) **Unsaturated oxygenated fluorocarbons for selective anisotropic etch applications**

(30) Priority: 15.07.2003 US 619911
(71) Applicant: AIR PRODUCTS AND CHEMICALS, INC., Allentown, PA 18195-1501 (US)
(72) Inventor: Ji, Bing, Allentown PA 18104 (US); Pearlstein, Ronald Martin, Macungie PA 18062 (US); Syvret, Robert George, Allentown PA 18103-5451 (US); Badowski, Peter R., White Haven PA 18661 (US); Motika, Stephen Andrew, Kutztown PA 19530 (US); Karwacki, Eugene Joseph Jr., Orefield PA 18069 (US); Berger, Kerry Renard, Lehighton PA 18235 (US)
(74) Representative: Schwabe - Sandmair - Marx

(57) **Abstract**

A mixture and a method comprising same for etching a dielectric material from a layered substrate are disclosed herein. Specifically, in one embodiment, there is provided a mixture for etching a dielectric material in a layered substrate comprising an unsaturated oxygenated fluorocarbon. The mixture of the present invention may be contacted with a layered substrate comprising a dielectric material under conditions sufficient to at least partially react with and remove at least a portion of the dielectric material. In another embodiment of the present invention, there is provided a method for making an unsaturated oxygenated fluorocarbon.

## Description

### BACKGROUND OF THE INVENTION

Dielectric materials are principally used for forming electrically insulating layers within, for example, an electronic device or integrated circuits (IC). Selective anisotropic etching of dielectric materials is the process step extensively used to produce features in the manufacturing of integrated circuits (IC), microelectromechanical systems (MEMS), optoelectronic devices, and micro-optoelectronic-mechanical systems (MOEMS).

Device features on a wafer are typically defined by patterned masks. These patterned masks are generally composed of an organic photoresist material; however "hard" mask materials, such as silicon nitride Si₃N₄, or other material that may be etched at a slower rate than the dielectric material, may also be used as the mask material. Selective anisotropic etching allows for the formation of features such as contact and via holes by removing at least a portion of the underlying dielectric material while essentially preserving the patterned mask. The dielectric materials to be selectively removed from under the mask openings include: silicon in its various forms such as crystalline silicon, polysilicon, amorphous silicon, and epitaxial silicon; compositions containing silicon such as silicon dioxide (SiO₂); undoped silicate glass (USG); doped silicate glass such as boron doped silicate glass (BSG); phosphorous doped silicate glass (PSG), and borophosphosilicate glass (BPSG); silicon and nitrogen containing materials such as silicon nitride (Si₃N₄), silicon carbonitride (SiCN) and silicon oxynitride (SiON); and materials having a low dielectric constant (e.g., having a dielectric constant of 4.2 or less) such as fluorine doped silicate glass (FSG), organosilicate glass (OSG), organofluoro-silicate glass (OFSG), polymeric materials such as silsesquioxanes (HSQ, HSiO_{1.5}) and methyl silsesquioxanes (MSQ, RSiO_{1.5} where R is a methyl group), and porous low dielectric constant materials.

Some of the key manufacturing requirements for selective anisotropic dielectric etching include: high etch rate of the underlying dielectric materials; zero or low loss of the patterned mask, i.e., high etch selectivity of the dielectric material over the mask material; maintaining the critical dimensions of the patterned mask; maintaining desired etch profile, i.e. high anisotropy; maintaining uniformity across the wafer; minimal variation over feature sizes and density, i.e., no microloading effects; high selectivity over underlying etch stop layer such as SiC, SiN, and silicon etc.; and sidewall passivation films that can be easily removed in post-etch ashing, stripping and/or rinsing. Of the foregoing requirements, achieving high etch selectivity of the dielectric materials over the mask material and maintaining the critical dimensions of the patterned mask may be the most important yet the most challenging performance requirements to obtain.

As the IC geometry shrinks, newer photoresist materials are increasingly being adopted for deep ultraviolet (DUV) photolithography at sub-200 nm, i.e., 193 nm, wavelengths. DUV photoresist materials are generally less resistant to plasma etching than older-generation photoresist materials. Further, the thickness of the DUV photoresist is typically only a few hundreds of nanometers, and in some instances less than 200 nm, because of the absorptivity of DUV light by the resist materials. Because of the limits set by dielectric break-down, the thickness of the dielectric layer are generally not reduced below 0.5 to 1 µm. However, the minimum feature sizes of the contact and via holes penetrating the dielectric layer may be below 0.5 µm. As a result, the holes etched within the dielectric material need to be highly anisotropic and have high aspect ratios (HAR), defined as the ratio of the depth to the minimum width of a hole. High aspect ratio (HAR) etching of dielectric materials may require via/trench depth of over several micrometers or an order of magnitude higher than the thickness of the DUV. The further evolution of photolithography technology to lower wavelengths, i.e., 157 nm and EUV photolithography, may lead to the need for even higher etch selectivity between the underlying dielectric materials and the photoresist materials.

Fluorocarbon plasmas are commonly used for selective anisotropic etching of silicon-containing dielectric materials such as SiO₂. The fluorocarbons used for selective anisotropic etching include: CF₄ (tetrafluoromethane), CHF₃ (trifluoromethane), C₄F₈ (octafluorocyclobutane), C₅F₈ (octafluorocyclopentene), and C₄F₆ (hexafluoro-1,3-butadiene). These fluorocarbons dissociate in plasma to form reactive fluorocarbon species, such as, for example CF, CF₂, C₂F₃ etc. The fluorocarbon species may provide the reactive source of fluorine to etch the underlying silicon-containing dielectric materials in the presence of, for example, energetic ion bombardment. Further, the fluorocarbon species may form a fluorocarbon polymer that protects the photoresist and the sidewalls of the etch features which is referred to herein as the polymerization reaction.

For selective anisotropic etching applications, the substrate typically contains one or more dielectric layers covered with a patterned photoresist coating to provide a feature such as a contact or via hole within the dielectric material. Depending on factors such as location, substrate chemistry, ion fluxes, etc., the fluorocarbon polymer may initiate distinctly different plasma-surface chemical reactions. For example, the fluorocarbon polymer may form a protective layer against sputtering damage of argon ions and/or other reactive species in the plasma at the photoresist surface. By contrast, the presence of oxygen within the dielectric material and high energy ions impinging upon the exposed dielectric surface may facilitate the formation of volatile species which is referred to herein as the etch reaction. The volatile species formed from the etch reaction can be readily removed from the reactor via vacuum pump or other means. However, the etch reaction does not typically occur on the sidewall surfaces of vias or trenches since there is no ion bombardment impinging upon the vertical surfaces. Therefore, the fluorocarbon polymer may provide a protective or passivation layer on the unexposed dielectric material such as feature sidewalls whereas the etch reaction of the fluorocarbon polymer with the exposed dielectric forms volatile species thereby removing the dielectric material. Thus, at the dielectric surface, the end-product of the polymerization reaction, or the fluorocarbon polymer, serves as source for the reactive fluorine in the etch reaction, provided that it can be adequately removed so that no fluorocarbon polymer accumulates on the exposed dielectric surface thereby impeding the etching process.

. To protect the exposed photoresist surface, it may be desirable to have a fluorocarbon plasma that is highly polymerizing to encourage the formation of the fluorocarbon polymer. However, at the exposed dielectric surface, if the etch reaction cannot compete with the polymerization reaction, the thin fluorocarbon film can accumulate and the etch process may stop. To optimize the competing reactions of etching and polymerization, molecular oxygen (O₂) is routinely added to the fluorocarbon etch plasma. The etch rate of the dielectric material may be increased if an optimal balance between the competing reactions can be achieved. Unfortunately, O₂ can attack the organic photoresist materials thereby increasing the photoresist etch rate. This may result in the undesirable decrease of etch selectivity of the dielectric material over the photoresist material within the substrate.

Over the years, the preferred fluorocarbon gases for selective anisotropic dielectric etching have evolved from a mixture of CF₄ and CHF₃, to C₄F₈, recently to C₅F₈, and more recently to C₄F₆. Until now, molecular oxygen (O₂) has been used as the oxidizer to fine-tune fluorocarbon plasmas to achieve the optimized balance between high etch rate of dielectric materials and high etch selectivity of dielectric over photoresist materials. However, the IC industry is approaching the limit of the O₂/fluorocarbon chemistry for the most demanding selective anisotropic HAR dielectric etching at deep micron feature sizes.

The prior art provides some alternatives to traditionally used fluorocarbons for various etching and/or cleaning applications. For example, US Patent 6,461,975 B1 and Japanese Patent Application JP 2001/168088A disclose the use of cyclic C₄HₓF₈₋ₓO, wherein x is an integer from 0 to 4 for etching insulating materials. International Patent Application WO-02/086192 A1 discloses the use of perfluoroketones (having 4 to 7 carbon atoms) as a vapor reactor cleaning, etching, and doping gas. Despite these alternatives, there remains a need in the art for an etch chemistry that can provide a higher etch rate of dielectric materials along with a higher etch selectivity of dielectric materials over photoresist masks.

All references cited herein are incorporated herein by reference in their entireties.

### BRIEF SUMMARY OF THE INVENTION

The present invention satisfies one, if not all, of the needs in the art by providing a mixture and a method for removing at least a portion of a dielectric material from a layered substrate. Specifically, in one aspect of the present invention, there is provided a mixture for etching a dielectric material in a layered substrate comprising: an unsaturated oxygenated fluorocarbon having the formula CₓF_{y}O_{z}R_{q} wherein R is a hydrogen atom, a hydrocarbyl group having a number of carbon atoms ranging from 1 to 5, a halocarbyl group having a number of carbon atoms ranging from 1 to 5, or a halohydrocarbyl group having a number of carbon atoms ranging from 1 to 5; x is a number ranging from 2 to 10; y is a number less than 2x-q, z is a number ranging from 1 to 2; and q is a number ranging from 0 to 1, and wherein the ratio of F atoms to C atoms is less than 2, provided that when x is a number ranging from 3 to 10, z is 1, and q is 0, the mixture further comprises an oxidizer wherein the ratio by volume of the oxidizer to the unsaturated oxygenated fluorocarbon ranges from 0:1 to 1.0:1.

In another aspect of the present invention, there is provided a mixture for removing a portion of a dielectric material in a layered substrate comprising an unsaturated oxygenated fluorocarbon having a ratio of fluorine atoms to carbon atoms less than 2 comprising at least one compound selected from the group consisting of epoxides, diepoxides, ketones, diketones, esters, ethers, acyl fluorides, diacyl fluorides, alcohols, aldehydes, peroxides, and combinations thereof. If the at least one compound is a ketone, the mixture further comprises an oxidizer wherein the ratio by volume of the oxidizer to the unsaturated oxygenated fluorocarbon ranges from 0:1 to 1.0:1.

In yet another aspect of the present invention, there is provided a method for the removal of a portion of a dielectric material from a layered substrate comprising: providing a gas mixture comprising an unsaturated oxygenated fluorocarbon having the formula CₓF_{y}O_{z}R_{q} wherein R is a hydrogen atom, a hydrocarbyl group having a number of carbon atoms ranging from 1 to 5, a halocarbyl group having a number of carbon atoms ranging from 1 to 5, or a halohydrocarbyl group having a number of carbon atoms ranging from 1 to 5; x is a number ranging from 2 to 10; y is a number less than 2x-q, z is a number ranging from 1 to 2; and q is a number ranging from 0 to 1, and wherein the ratio of F atoms to C atoms is less than 2, provided that when x is a number ranging from 3 to 10, y is a number less than 2x-q, z is 1, and q is 0, the mixture further comprises an oxidizer wherein the ratio by volume of the oxidizer to the unsaturated oxygenated fluorocarbon ranges from 0: 1 to 1.0:1; applying energy to the gas mixture to form active species; and contacting the layered substrate with the active species to remove the portion of the dielectric material.

In another aspect of the present invention, there is provided a method for A method for etching at least a portion of a dielectric material from a layered substrate comprising: providing a mixture comprising an unsaturated oxygenated fluorocarbon having the formula CₓF_{y}O_{z}R_{q} wherein R is a hydrogen atom, a hydrocarbyl group having a number of carbon atoms ranging from 1 to 5, a halocarbyl group having a number of carbon atoms ranging from 1 to 5, or a halohydrocarbyl group having a number of carbon atoms ranging from 1 to 5; x is a number ranging from 2 to 10; y is a number less than 2x-q; z is a number ranging from 1 to 2; and q is a number ranging from 0 to 1, wherein the F/C ratio is less than 2, and wherein the ratio by volume of the oxidizer to the unsaturated oxygenated fluorocarbon ranges from 0:1 to 1.0:1; and contacting the layered substrate with the mixture to at least partially react with and removes the at least a portion of the dielectric material.

In a further aspect of the present invention, there is provided a method for forming an epoxide having the formula CₓF_{y}O_{z} wherein x is a number ranging from 3 to 10; y is a number less than 2x-q, and z is 1 and wherein the ratio of F atoms to C atoms is less than 2, the method comprising: providing a reaction mixture comprising at least one solvent and a hypochlorite; adding at least one fluoroolefin comprising at least one double bond and having the formula C_{α}F_{β} where β <2α to the reaction mixture to at least partially react and form the epoxide; and removing at least a portion of the epoxide prior to the completion of the adding step.

These and other aspects of the present invention will be more apparent from the following description.

### BRIEF DESCRIPTION OF SEVERAL VIEWS OF THE DRAWINGS

Figure 1 provides an illustration of an apparatus used in one embodiment of the method of the present invention.

Figure 2 provides an example of a layered substrate.

Figure 3 provides a Scanning Electron Microscopy (SEM) image of a patterned wafer that was etched using one embodiment of the mixture of the present invention.

Figure 4 provides a Scanning Electron Microscopy (SEM) image of a patterned wafer that was etched using one embodiment of the mixture of the present invention.

### DETAILED DESCRIPTION OF THE INVENTION

The present invention provides a mixture and a method comprising same for the removal of at least a portion of a dielectric material from a layered substrate that uses an unsaturated oxygenated fluorocarbon. The unsaturated oxygenated fluorocarbon can be used with or without the addition of an oxidizer. The mixture and the method of the present invention may be used, for example, for selective anisotropic etching of a dielectric material from a layered substrate. In certain preferred embodiments, the mixture may be exposed to one or more energy sources sufficient to form active species, which then react with and remove the substance from the substrate. Also disclosed herein is a method for synthesizing an unsaturated oxygenated fluorocarbon.

In the present invention, it is believed that the use of an unsaturated oxygenated fluorocarbon having one or more oxygen atoms attached to the fluorocarbon molecules may react directly with the fluorocarbons species to achieve the optimal balance between the polymerization and etch reactions with little or no added molecular oxygen (O₂). As a result, the undesirable reaction between O₂ and photoresist materials is minimized or avoided. Further, it is believed that the use of highly unsaturated fluorocarbons having a ratio of fluorine atoms to carbon atoms, referred to herein as the F/C ratio, less than 2 may provide more resistance to the potentially adverse effects from the etch reaction. In this connection, it is believed that the etch plasma can form fluorocarbon polymers having a higher degree of cross -linking. Highly cross-linked fluorocarbon polymers may be more resistant to the etch reaction thereby providing better protection to the photoresist material and sidewalls.

As mentioned previously, the mixture of the present invention contains one or more unsaturated oxygenated fluorocarbons. Although the reactive agents and mixture used herein may be sometimes described herein as "gaseous", it is understood that the reagents may be delivered directly as a gas to the reactor, delivered as a vaporized liquid, a sublimed solid and/or transported by an inert diluent gas into the reactor. The term "unsaturated" fluorocarbon describes a molecule that contains at least one ring structure and/or at least one multiple bond (such as, for example, a C=C, C=C, or C=O bond). Further, the molecule should have sufficient unsaturation such that the ratio of the number of fluorine atoms and carbon atoms in the molecule, or F/C ratio, is less than 2.0. The term "oxygenated" fluorocarbon molecule describes a molecule that contains at least one oxygen atom. The oxygen atom may be bonded to the molecule, for example, as an ether functional group (i.e., C-O-C), a carbonyl functional group (i.e., C=O), an ester functional group (i.e. O=C-O-), and combinations thereof. Preferably, the unsaturated oxygenated fluorocarbons of the present invention are represented by the formula CₓF_{y}O_{z}R_{q} wherein R is a hydrogen atom, a hydrocarbyl group having a number of carbon atoms ranging from 1 to 5, preferably from 1 to 2, a halocarbyl group having a number of carbon atoms ranging from 1 to 5, preferably from 1 to 2, a halohydrocarbyl group having a number of carbon atoms ranging from 1 to 5, preferably from 1 to 2, x is a number ranging from 2 to 10, y is a number less than 2x-q, z is a number ranging from 1 to 2, and q is a number ranging from 0 to 1. The amount of unsaturated oxygenated fluorocarbon gas present in the mixture may range from 1 to 99%, preferably from 1 to 50%, and more preferably from 2 to 20% by volume. The ratio by volume of the oxidizer to unsaturated oxygenated fluorocarbon gas to within the mixture may range from 0:1 to 20:1, preferably from 0:1 to 10:1, and more preferably from 0:1 to 5:1. In certain embodiments such as when at least one of the unsaturated oxygenated fluorocarbon gas is a ketone, the ratio by volume of the oxidizer gas to the unsaturated oxygenated fluorocarbon gas may range from 0:1 to 1.0:1.

In the mixture of the present invention, the unsaturated oxygenated fluorocarbon is at least one selected from the group consisting of epoxides, diepoxides, ketones, diketones, esters, ethers, acyl fluorides, diacyl fluorides, alcohols, aldehydes, peroxides, and combinations thereof. Table I provides the ranges for the various types of unsaturated oxygenated fluorocarbons having the formula CₓF_{y}O_{z}R_{q}.

**Table I:**

| Unsaturated Oxygenated Fluorocarbons | | | | |
|---|---|---|---|---|
| Type | x | y | z | q |
| Epoxide | 3-10 | <2x-q | 1 | 0 |
| Diepoxide | 4-10 | <2x-q | 2 | 0 |
| Ketone | 3-10 | <2x-q | 1 | 0 |
| Diketone | 4-10 | <2x-q | 2 | 0 |
| Ester | 2-10 | <2x-q | 2 | 1 |
| Ether | 2-10 | <2x-q | 1 | 1 |
| Acyl Fluoride | 2-10 | <2x-q | 1 | 0 |
| Diacyl Fluoride | 3-10 | <2x-q | 2 | 0 |
| Alcohol | 2-10 | <2x-q | 1 | 1 |
| Aldehyde | 2-10 | <2x-q | 1 | 0 |
| Peroxide | 2-10 | <2x-q | 2 | 0-1 |

Examples of epoxides include perfluorocyclopentene oxide, hexafluorobutadiene epoxide, perfluorostyrene oxide, and epoxybutanyl fluoride. An example of a diepoxide includes hexafluorobutadiene diepoxide, hexafluorocyclopentadiene diepoxide, 1,1,2,3,4,5,5,5-octafluoro-1,3-pentadiene diepoxide, and 1, 1,2,3,3,4,5,5-octafluoro-1,4-pentadiene diepoxide. Examples of a ketone includes hexafluoro-cyclobutanone, perfluoroacetophenone, perfluorobenzophenone, and perfluoromethylvinylketone. An example of a diketone includes tetrafluorocyclobutanedione. An example of an ester includes pentafluorophenyltrifluoroacetate, trifluorovinyltrifluoroacetate, methyltrifluoroacrylate, trifluoromethyltrifluoroacrylate, and trifluoromethylpentafluoromethacrylate. Examples of ethers include hexafluorodihydrofuran, 2,2,3,3,5,6,-dihydro-[1,4]dioxine, methoxyheptafluorocyclobutane, and pentafluoro-1-methoxy-cyclobu-t-1-ene. Examples of acyl fluorides and diacyl fluorides include trifluoromethyl-tetrafluorobenzoyl fluoride, tetrafluorosuccinyl fluoride, trifluoroacryloyl fluoride, trifluoromethyl tetrafluorobenzoyl fluoride, and tetrafluorosuccinyl fluoride. Examples of an alcohol and an aldehyde includes heptafluorocyclobutanol and trifluoroethenal (perfluoroacrolein), respectively.

In certain embodiments, the unsaturated oxygenated fluorocarbon such as an epoxide may be synthesized by the epoxidation of a fluoro-olefin containing at least 1 C=C bond and having the formula C_{α}F_{β} where β < 2α. The fluoro-olefin is added to a reaction mixture containing a hypochlorite and a solvent. Suitable solvents include, but are not limited to, halocarbons (e. g. Freon 113); ethers (e. g. diethylether (Et₂O), di-n-butyl ether, 1,4-dioxane, or ethyl glycol dimethyl ether); nitriles (e. g. CH₃CN); or aromatic compounds (e.g. benzotrifluoride), alone or in admixture thereof. Suitable hypochlorites include sodium hypochlorite aqueous solutions and calcium hypochlorite. The reaction is preferably conducted in the presence of a base. The term "base" as used herein is any compound capable of removing an acidic proton and include compounds such as, but not limited to, amine, hydroxide, halide, alkoxide, amide, organolithium, or organomagnesium ions. The reaction temperature may range from -20°C to 60°C. The unsaturated oxygenated fluorocarbon is removed continuously from the reaction mixture and purified by standard procedures such as distillation, chromatography, recrystallization, and/or trituration before the fluoro-olefin prior to the completion of the reaction. The substrate fluoroolefin is preferably added to the reaction mixture at a rate such that the end-product fluoroepoxide can be removed continuously from the reaction mixture with acceptable purity during the reaction.

As mentioned previously, the mixture may further comprise an oxidizer such as, for example, O₂, O₃, CO, CO₂, and N₂O. In these embodiments, the amount of oxidizer present in the mixture may range from 0 to 99%, preferably from 0 to 75%, and more preferably from 0 to 50% by volume.

In addition to the reactive agents described herein, inert diluent gases such as argon, nitrogen, helium, neon, krypton, xenon or combinations thereof can also be added. Inert diluent gases can, for example, modify the plasma characteristics to better suit some specific applications. In addition, ions from inert gases such as, for example, argon may provide the energetic bombardment to facilitate the selective anisotropic etch reactions. The concentration of the inert gas within the mixture can range from 0 to 99%, preferably from 25 to 99%, and more preferably from 50 to 99% by volume.

The mixture may further comprise one or more conventional fluorocarbons. Examples of "conventional fluorocarbons" includes perfluorocarbons (compounds containing C and F atoms), hydrofluorocarbons (compounds containing C, H, and F), oxyhydrofluorocarbons (compounds containing C, H, O, and F), and oxyfluorocarbons (compounds containing C, O, and F). In one embodiment, the perfluorocarbon is a compound having the formula CₕFᵢ wherein h is a number ranging from 1 to 10 and i is a number ranging from h to 2h+2. Examples of perfluorocarbons having the formula CₕFᵢ include, but are not limited to, CF₄ (tetrafluoromethane), C₄F₈ (octafluorocyclobutane), C₅F₈ (octafluorocyclopentene), and C₄F₆ (hexafluoro-1,3-butadiene). In another embodiment, the fluorocarbon is a hydrofluorocarbon compound having the formula CⱼHₖFₗ wherein j is a number from 1 to 10, and k and l are positive integers with (k + l) from j to 2j + 2. An example of a hydrofluorocarbon compound having the formula CⱼHₖFₗ includes CHF₃ (trifluoromethane). In addition, oxyfluorocarbons such as, for example, C₄F₈O (perfluorotetrahydrofuran) and oxyhydrofluorocarbons such as, for example, heptafluoroisopropanol can also be used. The amount of fluorocarbon gas present in the mixture may range from 0 to 99%, preferably from 0 to 50%, and more preferably from 0 to 20% by volume.

While the above examples disclosed herein used oxygenated unsaturated fluorocarbons with a small amount of an oxidizer and optionally a diluent gas, there are many other ways to carry out the invention. For example, an oxygenated unsaturated fluorocarbon molecule can be used without the addition of an oxidizer. In this regard, one can select the F, C, and O atomic ratios in the oxygenated unsaturated fluorocarbon molecule that suits a particular type of dielectric substrate to obtain an optimal balance between the competing polymerization and etch reactions without the need for additional oxidizers. Further, the oxygenated unsaturated fluorocarbon molecules of the present invention can be used in conjunction with other unsaturated fluorocarbon molecules, such as, for example C₄F₆O₂ + C₄F₆, etc. Combination of these two kinds of compounds can provide the desired optimal balance between, for example, SiO₂ etch rate and SiO₂/photoresist etch selectivity by taking advantage of desirable features from both molecules. In another embodiment of the present invention, an oxygenated unsaturated fluorocarbon molecule can be delivered as an admixture with other gases and/or diluents into the reaction chamber. Exemplary admixtures include C₅F₈O + C₅F₈, C₅F₈O + O₂, C₅F₈O +Ar, C₄F₆O₂ + C₄F₆, C₄F₆O + Ar, etc. A predetermined optimal admixture can minimize process upset due to mass flow controller fluctuation and drift.

The chemical reagents can be delivered to the reaction chamber by a variety of means, such as, for example, conventional cylinders, safe delivery systems, vacuum delivery systems, solid or liquid-based generators that create the chemical reagent and/or the gas mixture at the point of use (POU).

The process of the invention is useful for etching substances such as a dielectric material from a substrate. Suitable substrates that may be used include, but are not limited to, semiconductor materials such as gallium arsenide ("GaAs"), boron nitride ("BN"), silicon in its various forms such as crystalline silicon, polysilicon, amorphous silicon, and epitaxial silicon, compositions containing silicon such as silicon dioxide ("SiO₂"), silicon carbide ("SiC"), silicon oxycarbide ("SiOC"), silicon nitride ("SiN"), silicon carbonitride ("SiCN"), organosilicate glasses ("OSG"), organofluorosilicate glasses ("OFSG"), fluorosilicate glasses ("FSG"), and other appropriate substrates or mixtures thereof. Substrates may further comprise a variety of layers that include, for example, antireflective coatings, photoresists, organic polymers, porous organic and inorganic materials, metals such as copper and aluminum, or diffusion barrier layers, e.g., TiN, Ti(C)N, TaN, Ta(C)N, Ta, W, WN, or W(C)N.

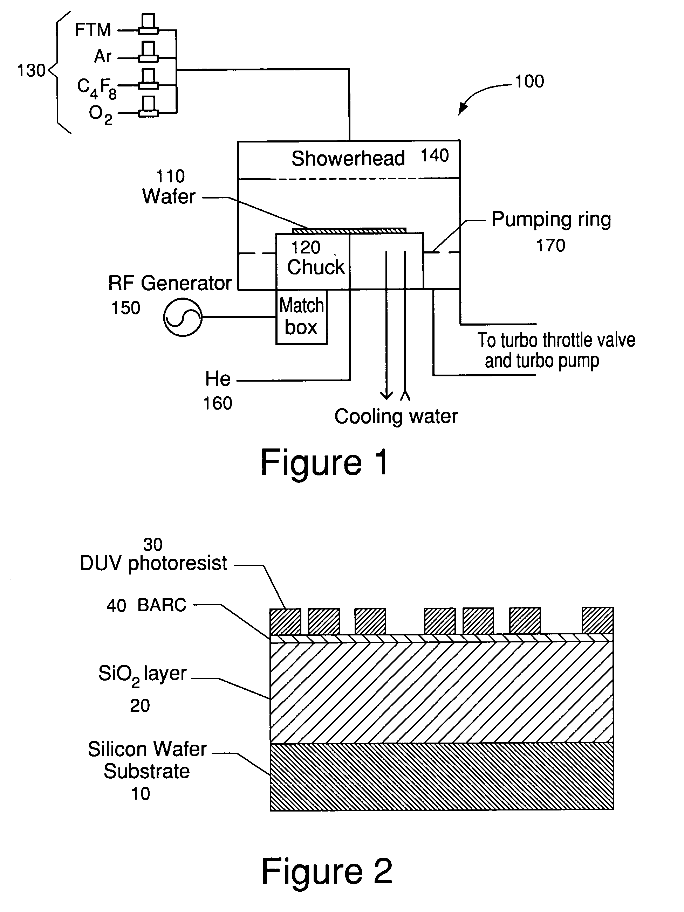

Figure 2 provides an example of a layered silicon wafer substrate 10 that is suitable for etching using the method of the present invention. Substrate 10 has a dielectric layer 20 such as SiO₂ deposited thereupon. A mask layer 30 such as a DUV photoresist is applied to dielectric layer 20 atop a back-side anti-reflective coating (BARC). Mask or photoresist layer 30 is depicted as being patterned. A patterned photoresist is typically formed by exposing the substrate to a radiation source to provide an image, and developing the substrate to form a patterned photoresist layer on the substrate. This patterned layer then acts as a mask for subsequent substrate patterning processes such as etching, doping, and/or coating with metals, other semiconductor materials, or insulating materials. The selective anisotropic etching process generally involves removing the portion of the substrate surface that is not protected by the patterned photoresist thereby exposing the underlying surface for further processing.

The mixture of the present invention is exposed to one or more energy sources sufficient to generate active species to at least partially react with the dielectric material and form volatile species. The energy source for the exposing step may include, but not be limited to, α-particles, β-particles, γ-rays, x-rays, high energy electron, electron beam sources of energy, ultraviolet (wavelengths ranging from 10 to 400 nm), visible (wavelengths ranging from 400 to 750 nm), infrared (wavelengths ranging from 750 to 10⁵ nm), microwave (frequency > 10⁹ Hz), radio-frequency wave (frequency > 10⁶ Hz) energy; thermal, RF, DC, arc or corona discharge, sonic, ultrasonic or megasonic energy, and combinations thereof.

In one embodiment, the mixture is exposed to an energy source sufficient to generate a plasma having active species contained therein. Specific examples of using the plasma for etching processes include, but are not limited to, reactive ion etch (RIE), magnetically enhanced reactive ion etch (MERIE), a inductively coupled plasma (ICP) with or without a separate bias power source, transformer coupled plasma (TCP), hollow anode type plasma, helical resonator plasma, electron cyclotron resonance (ECR) with or without a separate bias power source, RF or microwave excited high density plasma source with or without a separate bias power source, etc. In embodiments wherein a RIE process is employed, the etching process is conducted using a capacitively coupled parallel plate reaction chamber. In these embodiments, the layered substrate (e.g., a patterned wafer) may be placed onto a RF powered lower electrode within a reaction chamber. The substrate is held onto the electrode by either a mechanical clamping ring or an electrostatic chuck. The backside of the substrate may be cooled with an inert gas such as helium. The RF power source may be, for example, an RF generator operating at a frequency of 13.56 MHz, however other frequencies can also be used. The RF power density can vary from 0.3 to 30 W/cm², preferably from 1 to 16 W/cm². The operating pressure can vary from 0.1 to 10,000 mTorr, preferably from 1 to 1000 mTorr, and more preferably from 1 to 100 mTorr. The flow rate of the mixture into the reaction chamber ranges from 10 to 50,000 standard cubic centimeters per minute (sccm), preferably from 20 to 10,000 sccm, and more preferably from 25 to 1,000 sccm.

The invention will be illustrated in more detail with reference to the following examples, but it should be understood that the present invention is not deemed to be limited thereto.

### EXAMPLES

The following examples were conducted in a commercial production scale Applied Materials P-5000 Mark II reactor similar to the setup illustrated in Fig. 1. For each experimental run, a substrate 110 was loaded onto the reactor chuck 120. Process gases 130 were fed into the reactor 100 from a top mounted showerhead 140. The chuck was then powered by a 13.56 MHz RF power source 150 to generate the plasma (not shown). The chuck has a helium backside cooling system 160. Volatile species (not shown) are removed from the reaction chamber 100 through a pumping ring 170 by a turbo pump (not shown). Pumping ring 170 creates an axially symmetric pathway to pump out the gases and volatile species contained therein.

The Applied Materials P-5000 Mark II reactor operates in a capacitively coupled RIE mode with magnetic confinement to increase plasma density and hence to improve etch rate and uniformity. This type of reactor is often termed as magnetically enhanced reactive ion etcher (MERIE). The Applied Materials Mark II reactor uses a clamping ring mechanical chuck and helium backside cooling at 8 Torr for processing 200 mm wafers. The wafer chuck is water cooled at 20°C.

To facilitate selective anisotropic etching, inert gases such as argon are often used as the diluent with the above etchants. In the following examples unless stated otherwise, the reactor was powered at 13.56 MHz at 1000 W, or approximately 3 W/cm² power density. This resulted in a typical direct current (DC) bias voltage of about -900V. The chamber pressure was kept at 35 mTorr. The magnetic field was set at 50 Gauss.

Scanning Electron Microscopy (SEM) was performed on a cross section of a piece of a cleaved patterned wafer fragment at a magnification of 35,000 times.

### Example 1: Synthesis of Perfluorocyclopentene Oxide (C₅F₈O)

A 500 mL 3-necked flask was submerged in an ice-water bath and fitted with a cold-finger condenser chilled with solid carbon dioxide, a magnetic stirrer and thermometer. Into the flask were added: 180 mL of sodium hypochlorite solution (13 weight % active chlorine) and 19 mL of sodium hydroxide solution (50 weight%) followed by 68 mL of acetonitrile to provide a reaction mixture. The reaction mixture was stirred to combine and allowed to cool for 10 minutes until the temperature reached approximately 12°C.

Vigorous magnetic stirring was initiated and 22 mL of octafluorocyclopentene was added by syringe pump at a rate of approximately 0.67 mL/minute through a perfluorocarbon polymer tube submerged below the surface of the reaction mixture. The pot temperature was controlled at approximately 20°C by adjusting the temperature of the cold water bath surrounding the flask. After about half of the addition octafluorocyclopentene is completed, the product, epoxyperfluorocyclopentene (C₅F₈O), was collected in a receiver chilled with solid carbon dioxide. The first small portion (about 1 g) collected is contaminated with unreacted starting material and is discarded, thereafter a very pure (typically >95%) product is obtained. After addition is complete, the reaction mass is warmed up to 60°C and collection of product continues until the distillate temperature exceeds 30°C. Isolated yield is 8 g of C₅F₈O identified by ¹⁹F NMR obtained on a Bruker CP-500FT spectrometer operating at 470.68 MHz Chemical shifts were referenced to neat CFCl₃(¹⁹F). The end-product purity was also confirmed via FTIR spectroscopy with a Nicolet Avatar 360 spectrometer using a 10 cm path length gas cell, and by gas chromatography using a Hewlett Packard 5890 Series II G.C. and 5972 series mass selective detector.

### Example 2: Unpatterned Wafer Etching Using Perfluorocyclopentene Oxide (C₅F₈O)

A set of experiments were performed using perfluorocyclopentene oxide C₅F₈O to etch unpatterned wafers. The C₅F₈O was prepared in accordance with the method described in example 1. These unpatterned wafers were coated either with 1 micrometer thick SiO₂ film deposited by plasma enhanced chemical vapor deposition of tetraethylorthosilicate (PECVD-TEOS), or with about 400 nm thick 193 nm photoresist by spin-on. Film thickness was measured by reflectometer before and after plasma etching to determine etch rate. Table 1 lists the recipes and the results. In all experiments in Table 1, the total feed gas flow was kept at 200 standard cubic centimeter per minute (sccm) with argon as the diluent.

It can be seen from Table 1 that higher O₂/C₅F₈O molar ratio enhances SiO₂ etch rate, but decreases SiO₂/photoresist etch selectivity due to simultaneous increase of photoresist etch rate. Lower C₅F₈O molar concentration improves SiO₂/photoresist etch selectivity, but also lowers SiO₂ etch rate. Therefore, both high SiO₂ etch rate and high SiO₂/photoresist selectivity can be achieved by optimization of C₅F₈O molar concentration and O₂/C₅F₈O molar ratio. Note that the amount of oxygen needed for optimal balance between etch rate and etch selectivity is less than that needed for C₅F₈ etch chemistry. This demonstrates the novelty of this invention: by incorporating an oxygen atom onto the unsaturated fluorocarbon molecule, less molecular oxygen is needed in the etch recipe resulting in higher SiO₂/photoresist etch selectivity.

**Table 1.**

| C₅F₈O Unpatterned Wafer Etch Results | | | | |
|---|---|---|---|---|
| C₅F₈O mole% | O₂/C₅F₈O molar ratio | SiO₂ etch rate (nm/min) | Photoresist etch rate (nm/min) | SiO₂/photoresist etch selectivity |
| 10 | 0.375 | 304 | 55 | 5.55 |
| 10 | 0.500 | 314 | 67 | 4.68 |
| 10 | 0.250 | 199 | 45 | 4.38 |
| 7 | 0.375 | 281 | 51 | 5.50 |

### Example 3: Patterned Wafer Etching Using Perfluorocyclopentene Oxide (C₅F₈O)

Experiments were conducted on patterned wafers similar to that depicted in Figure 2. About 2 micrometer thick of SiO2 film was deposited onto a unpatterned silicon wafer by plasma enhanced chemical vapor deposition (PECVD). The wafer was then coated with bottom antireflective coating (BARC) and deep UV (DUV) photoresist and subsequently patterned with a set of vias with various diameters from 0.30 to 0.50 micrometers. The photoresist layer thickness before plasma etching was determined by scanning electron microscopy (SEM).

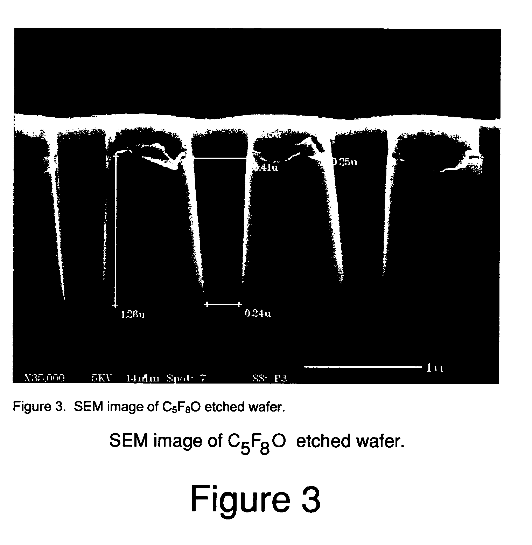

Before etching the underlying dielectric layer, the BARC layer was first opened up by running a standard CF₄ BARC open recipe for 60 seconds. The main dielectric etch step was then carried out with the following recipe: 20 sccm C₅F₈O, 15 sccm O₂, 165 sccm argon, chamber pressure 35 mTorr, and RF power 1000 W. Figure 3 is the SEM image of the etched wafer. As shown in Figure 3, a satisfactory etch performance was achieved.

### Example 4: Patterned Wafer Etching Using Perfluorocyclopentene Oxide (C₅F₈O)

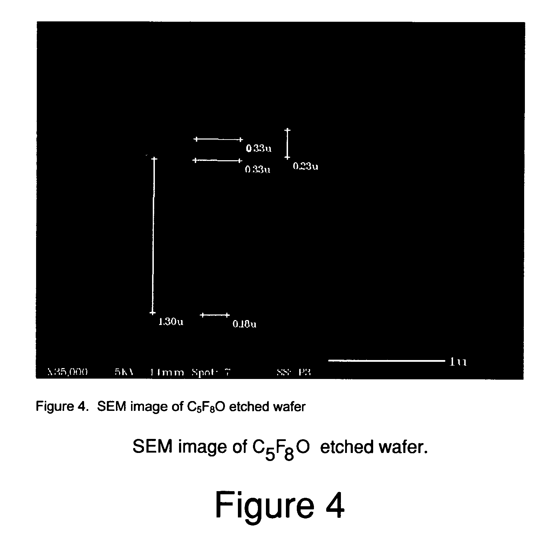

This example used a slightly higher C₅F₈O concentration (13 mole%) than that in example 3. The dielectric etch recipe was: 26 sccm C₅F₈O, 20 sccm O₂, 155 sccm argon, chamber pressure 35 mTorr, and RF power 1000 W. Figure 4 shows the SEM image of the etched wafer. Again, satisfactory etch performance was achieved.

### Example 5: Comparative Example of Using C₄F₈O Having a F/C Ratio = 2 for Unpattemed Wafer Etching

Table 2 lists the recipes and results of using C₄F₈O (perfluorotetrahydrofuran) for unpatterned wafer etching. The experiments were also carried out in the Applied Materials P-5000 Mark II reactor at 35 mTorr pressure, 1000 W RF power at 13.56 MHz, and 50 Gauss magnetic field.

A comparison between the results in Table 2 and Table 1 clearly shows that C₄F₈O yielded inferior results. Particularly, the photoresist etch rates were roughly a factor of two higher than that of the C₅F₈O results, even without additional oxygen. Adding O₂ to the C₄F₈O plasma yielded even higher photoresist etch rate, hence even lower SiO₂/photoresist selectivity. Since C₄F₈O has an F/C ratio of 2.0, this comparative example demonstrates the superior etch selectivity derived from the higher degree of unsaturation (i.e., F/C less than 2.0) in the disclosed molecules in this invention.

**Table 2.**

| C₄F₈O Unpattemed Wafer Etching Results | | | | |
|---|---|---|---|---|
| C₄F₈O Flow (sccm) | Ar Flow (sccm) | SiO₂ etch rate (nm/min) | Photoresist etch rate (nm/min) | SiO₂/photoresist selectivity |
| 16 | 184 | 268 | 137 | 1.96 |
| 20 | 131 | 275 | 112 | 2.45 |
| 36 | 164 | 337 | 120 | 2.82 |
| 15 | 135 | 271 | 107 | 2.53 |
| 30 | 120 | 384 | 117 | 3.27 |

While the invention has been described in detail and with reference to specific examples thereof, it will be apparent to one skilled in the art that various changes and modifications can be made therein without departing from the spirit and scope thereof.

## Claims

1. A mixture for etching a dielectric material in a layered substrate, the mixture comprising:
an unsaturated oxygenated fluorocarbon having the formula CₓF_{y}O_{z}R_{q} wherein R is a hydrogen atom, a hydrocarbyl group having a number of carbon atoms ranging from 1 to 5, a halocarbyl group having a number of carbon atoms ranging from 1 to 5, or a halohydrocarbyl group having a number of carbon atoms ranging from 1 to 5; x is a number ranging from 2 to 10; y is a number less than 2x-q, z is a number ranging from 1 to 2; and q is a number ranging from 0 to 1, and wherein the ratio of F atoms to C atoms is less than 2,
provided that when x is a number ranging from 3 to 10, y is a number less than 2x-q, z is 1, and q is 0, the mixture further comprises an oxidizer wherein the ratio by volume of the oxidizer to the unsaturated oxygenated fluorocarbon ranges from 0:1 to 1.0:1.

2. The mixture further comprising at least one inert diluent gas selected from the group consisting of argon, neon, xenon, helium, nitrogen, krypton, and combinations thereof.

3. The mixture of claim 1 wherein the mixture comprises from 0.1 to 99% by volume of the inert diluent gas.

4. The mixture of claim 1 wherein the unsaturated oxygenated fluorocarbon is at least one compound selected from the group consisting of epoxides, diepoxides, ketones, diketones, esters, ethers, acyl fluorides, diacyl fluorides, alcohols, aldehydes, peroxides, and combinations thereof.

5. The mixture of claim 1 wherein the oxidizer is at least one selected from the group consisting of O₃, O₂, CO, CO₂, N₂O and combinations thereof.

6. The mixture of claim 1 wherein the mixture comprises 1 to 99% by volume of the unsaturated oxygenated fluorocarbon.

7. The mixture of claim 1 wherein the mixture comprises 0 to 99% by volume of the oxidizer.

8. The mixture of claim 1 wherein the dielectric material is comprised of at least one selected from the group consisting of silicon, compositions comprising silicon, silicon dioxide (SiO₂), undoped silicon glass (USG), doped silica glass, silicon and nitride containing materials, organosilicate glass (OSG), organofluoro-silicate glass (OFSG), low dielectric constant materials, polymeric materials, porous low dielectric constant materials, and combinations thereof.

9. A mixture for removing a portion of a dielectric material in a layered substrate comprising an unsaturated oxygenated fluorocarbon comprising an epoxide having the formula CₓF_{y}O_{z} wherein x is a number ranging from 3 to 10; y is a number less than 2x-q; and z is 1 and wherein the ratio of F atoms to C atoms is less than 2.

10. A mixture for removing a portion of a dielectric material in a layered substrate comprising an unsaturated oxygenated fluorocarbon comprising a diepoxide having the formula CₓF_{y}O_{z} wherein x is a number ranging from 4 to 10; y is a number less than 2x-q; z is 2; and wherein the ratio of F atoms to C atoms is less than 2.

11. A mixture for removing a portion of a dielectric material in a layered substrate comprising an unsaturated oxygenated fluorocarbon comprising a ketone having the formula CₓF_{y}O_{z} wherein x is a number ranging from 3 to 10; y is a number less than 2x-q; and z is 1 wherein the ratio of F atoms to C atoms is less than 2, and an oxidizer wherein the ratio by volume of oxidizer to the unsaturated oxygenated from 0:1 to 1.0:1.

12. A mixture for removing a portion of a dielectric material in a layered substrate comprising an unsaturated oxygenated fluorocarbon comprising a diketone having the formula CₓF_{y}O_{z} wherein x is a number ranging from 4 to 10; y is a number less than 2x-q; z is 2, and wherein the ratio of F atoms to C atoms is less than 2.

13. A mixture for removing a portion of a dielectric material in a layered substrate comprising an unsaturated oxygenated fluorocarbon comprising an ester having the formula CₓF_{y}O_{z}R_{q} wherein R is a hydrocarbyl group having a number of carbon atoms ranging from 1 to 5, a halocarbyl group having a number of carbon atoms ranging from 1 to 5, or a halohydrocarbyl group having a number of carbon atoms ranging from 1 to 5; x is a number ranging from 2 to 10; y is a number less than 2x-q; z is 2; and q is 1, and wherein the ratio of F atoms to C atoms is less than 2.

14. A mixture for removing a portion of a dielectric material in a layered substrate comprising an unsaturated oxygenated fluorocarbon comprising an ether having the formula CₓF_{y}O_{z}R_{q} wherein R is a hydrocarbyl group having a number of carbon atoms ranging from 1 to 5, a halocarbyl group having a number of carbon atoms ranging from 1 to 5; or a halohydrocarbyl group having a number of carbon atoms ranging from 1 to 5; x is a number ranging from 2 to 10; y is a number less than 2x-q; z is 1; and q is 1, and wherein the ratio of F atoms to C atoms is less than 2.

15. A mixture for removing a portion of a dielectric material in a layered substrate comprising an unsaturated oxygenated fluorocarbon comprising an acyl fluoride having the formula CₓF_{y}O_{z} wherein x is a number ranging from 2 to 10; y is a number less than 2x-q; and z is 1; and wherein the ratio of F atoms to C atoms is less than 2.

16. A mixture for removing a portion of a dielectric material in a layered substrate comprising an unsaturated oxygenated fluorocarbon comprising a diacyl fluoride having the formula CₓF_{y}O_{z} wherein x is a number ranging from 3 to 10; y is a number less than 2x-q, z is 2, and wherein the ratio of F atoms to C atoms is less than 2.

17. A mixture for removing a portion of a dielectric material in a layered substrate comprising an unsaturated oxygenated fluorocarbon comprising an alcohol having the formula CₓF_{y}O_{z}R_{q} wherein R_{q} = H, x is a number ranging from 2 to 10; y is a number less than 2x-q; z is 1; and q is 1, and wherein the ratio of F atoms to C atoms is less than 2.

18. A mixture for removing a portion of a dielectric material in a layered substrate comprising an unsaturated oxygenated fluorocarbon comprising an aldehyde having the formula CₓF_{y}O_{z} wherein x is a number ranging from 2 to 10; y is a number less than 2x-q; z is 1 and at least one hydrogen atom bond to a carbonyl carbon and wherein the ratio of F atoms to C atoms is less than 2.

19. A mixture for removing a portion of a dielectric material in a layered substrate comprising an unsaturated oxygenated fluorocarbon comprising a peroxide having the formula CₓF_{y}O_{z}R_{q} wherein R is a hydrogen atom, a hydrocarbyl group having a number of carbon atoms ranging from 1 to 5, a halocarbyl group having a number of carbon atoms ranging from 1 to 5, or a halohydrocarbyl group having a number of carbon atoms ranging from 1 to 5; x is a number ranging from 2 to 10; y is a number less than 2x-q; z is 2; and q is a number ranging from 0 to 1, and wherein the ratio of F atoms to C atoms is less than 2.

20. A method for the removal of a portion of a dielectric material from a layered substrate, the method comprising:
providing a gas mixture comprising an unsaturated oxygenated fluorocarbon having the formula CₓF_{y}O_{z}R_{q} wherein R is a hydrogen atom, a hydrocarbyl group having a number of carbon atoms ranging from 1 to 5, a halocarbyl group having a number of carbon atoms ranging from 1 to 5, or a halohydrocarbyl group having a number of carbon atoms ranging from 1 to 5; x is a number ranging from 2 to 10; y is a number less than 2x-q; z is a number ranging from 1 to 2; and q is a number ranging from 0 to 1, and wherein the ratio of F atoms to C atoms is less than 2, provided that when x is a number ranging from 3 to 10; y is a number less than 2x-q; z is 1; and q is 0, the mixture further comprises an oxidizer wherein the ratio by volume of the oxidizer to the unsaturated oxygenated fluorocarbon ranges from 0:1 to 1.0:1;
applying energy to the gas mixture to form active species; and
contacting the layered substrate with the active species to remove the portion of the dielectric material.

21. The method of claim 20 wherein the gas mixture has a pressure ranging from 0.1 to 10,000 mTorr.

22. The method of claim 20 wherein the flow rate of the gas mixture ranges from 10 to 50,000 standard cubic centimeters per minute (sccm).

23. The method of claim 20 wherein the gas mixture is provided through at least one method selected from the group consisting of conventional cylinders, safe delivery systems, vacuum delivery systems, solid-based generators, liquid-based generators, point of use generators, and combinations thereof.

24. A method for etching at least a portion of a dielectric material from a layered substrate, the method comprising:
providing a mixture comprising an unsaturated oxygenated fluorocarbon having the formula CₓF_{y}O_{z}R_{q}
wherein R is a hydrogen atom, a hydrocarbyl group having a number of carbon atoms ranging from 1 to 5, a halocarbyl group having a number of carbon atoms ranging from 1 to 5, or a halohydrocarbyl group having a number of carbon atoms ranging from 1 to 5; x is a number ranging from 2 to 10; y is a number less than 2x-q; z is a number ranging from 1 to 2; and q is a number ranging from 0 to 1,
wherein the F/C ratio is less than 2, and
wherein the ratio by volume of the oxidizer to the unsaturated oxygenated fluorocarbon ranges from 0:1 to 1.0:1; and
contacting the layered substrate with the mixture to at least partially react with and removes the at least a portion of the dielectric material.

25. A method for forming an epoxide having the formula CₓF_{y}O_{z} wherein x is a number ranging from 3 to 10; y is a number less than 2x-q; and z is 1 and wherein the ratio of F atoms to C atoms is less than 2, the method comprising:
providing a reaction mixture comprising at least one solvent and a hypochlorite;
adding at least one fluoroolefin comprising at least one double bond and having the formula C_{α}F_{β} where β<2α to the reaction mixture to at least partially react and form the epoxide; and
removing at least a portion of the epoxide prior to the completion of the adding step.
